# EUROPÄISCHE PATENTSCHRIFT

(11) **EP 1 297 574 B1**
(45) Veröffentlichungstag und Bekanntmachung des Hinweises auf die Patenterteilung: **02.05.2007**
(21) Anmeldenummer: 01937987.4
(22) Anmeldetag: 14.04.2001
(51) Int. Cl.: H01L 27/02

(54) **SCHUTZVORRICHTUNG GEGEN ELEKTROSTATISCHE ENTLADUNGEN**
PROTECTION DEVICE AGAINST ELECTROSTATIC DISCHARGES
DISPOSITIF DE PROTECTION CONTRE LES DECHARGES ELECTROSTATIQUES

(30) Priorität: 06.06.2000 DE 10028008
(43) Veröffentlichungstag der Anmeldung: 02.04.2003
(73) Patentinhaber: ROBERT BOSCH GMBH, 70442 Stuttgart (DE)
(72) Erfinder: METTLER, Stephan, 72770 Reutlingen (DE); WILKENING, Wolfgang, 72793 Pfullingen (DE)
(86) Internationale Anmeldenummer: PCT/DE2001/001471
(87) Internationale Veröffentlichungsnummer: WO 2001/095395

(56) Entgegenhaltungen:
- EP-A- 0 098 383
- EP-A- 0 532 481
- EP-A- 0 932 203
- US-A- 4 390 890
- US-A- 4 595 943
- US-A- 5 212 618

## Beschreibung

### Stand der Technik

Die Erfindung geht aus von einer Schutzvorrichtung nach der Gattung des unabhängigen Anspruchs. Aus der DE 197 46 410 ist bereits eine solche Schutzvorrichtung bekannt, bei der im ESD-Fall (ESD ist die Abkürzung für den englischen Ausdruck für elektrostatische Entladung, "Electrostatic Discharge") eine vertikal angeordnete Transistordiode durch einen lateralen Sperrschichtberührungseffekt (englisch: "punch-through-effect") durchgeschaltet wird. Bei der dort beschriebenen Schutzvorrichtung jedoch ist die Durchbruchspannung typischerweise doppelt so groß wie die Haltespannung (englisch:"snap back voltage"), d.h. wie die Spannung, die mindestens zwischen Kollektor und Emitter nach dem Durchbruch anliegen muß, damit die Diode durchgeschaltet bleibt.

### Vorteile der Erfindung

Die erfindungsgemäße Schutzvorrichtung mit den kennzeichnenden Merkmalen des unabhängigen Anspruchs hat demgegenüber den Vorteil einer kleineren Differenz zwischen Durchbruchspannung und Haltespannung. Als betriebssicher werden nämlich in der Regel Schutzstrukturen angesehen, deren Haltespannung oberhalb der Betriebsspannung der zu schützenden Schaltung liegt und deren Durchbruchspannung unterhalb der technologiebedingten Spannungsfestigkeit der zu schützenden Schaltung liegt. Ist nun erforderlich, zwei Schutzelemente in Reihe zu schalten, damit die Haltespannung oberhalb der Betriebsspannung liegt, so verdoppelt sich neben der Haltespannung auch die Durchbruchspannung. Der resultierende Wert für die Durchbruchspannung kann jedoch für die Schaltung zu hoch sein. Die der Basisemitterstruktur vorgeschaltete laterale Diode ermöglicht in vorteilhafter Weise ein Unterschreiten einer unteren Grenze der Durchbruchspannung, die bislang durch die minimale Feldoxidausdehnung zwischen der Basisemitterstruktur und dem Kollektoranschluß gegeben war. Diese verringerte Durchbruchspannung ist also bei Serienschaltungen von Schutzelementen entscheidend für einen kostengünstigen Einsatz, damit auch integrierte Schaltkreise mit hohen Versorgungsspannungen abgesichert werden können. Auch die Kombination (Hintereinanderschaltung) mit anderen ESD-Schutzelementen wird verbessert, um spezielle "Schutzfenster" einstellen zu können (Versorgungspotential der zu schützenden Schaltung als untere Grenze für die Haltespannung, die zulässige Höchstspannung der zu schützenden Schaltung als untere Grenze für die Durchbruchspannung).

Durch die in den abhängigen Ansprüchen und der Beschreibung aufgeführten Maßnahmen sind vorteilhafte Weiterbildungen und Verbesserungen der im Hauptanspruch angegebenen Schutzvorrichtungen möglich. Besonders vorteilhaft ist das Vorsehen einer zusätzlichen Diodenwanne für die integrierte laterale Diode, wodurch die Durchbruchspannung der Schutzanordnung weiter erniedrigt werden kann.

Darüber hinaus kann die Durchbruchspannung weiterhin durch Einstellen des Abstands zwischen der Anschlußstruktur und der integrierten lateralen Diode variiert werden.

Das Vorsehen einer eingelassenen Elektrode ermöglicht eine verbesserte Anbindung der vergrabenen Schicht an die Kollektorelektrode und gewährleistet gleichzeitig einen besseren Schutz der Schaltung bzw. umliegender Schaltungsteile vor welchselseitigem Einflüssen.

Eine Anschlußschicht der Anschlußstruktur kann darüber hinaus so gewählt werden, daß im wesentlichen unabhängig von der Durchbruchspannung die Haltespannung geeignet bemessen ist.

Weitere Vorteile ergeben sich durch die in weiteren abhängigen Ansprüchen und in der Beschreibung genannten Merkmale.

### Zeichnung

Ausführungsbeispiele der Erfindung sind in der Zeichnung dargestellt und in der nachfolgenden Beschreibung näher erläutert. Es zeigen:
- Figur 1: eine aus der DE 197 46 410 bekannte Anordnung,
- Figur 2: ein erstes Ausführungsbeispiel,
- Figur 3: ein zweites Ausführungsbeispiel,
- Figur 4: ein Stromspannungsdiagramm und
- Figur 5: ein weiteres Ausführungsbeispiel

### Beschreibung der Ausführungsbeispiele

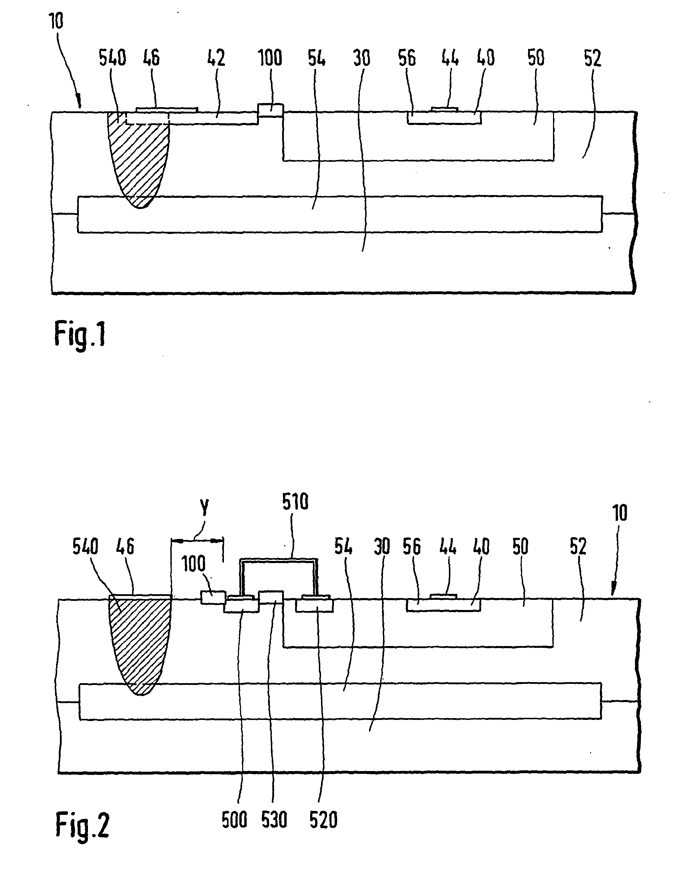

Figur 1 zeigt die Querschnittsseitenansicht einer Schutzvorrichtung, die auf einem p-dotierten Halbleitersubstat 30 angeordnet ist. Auf das Substrat 30 ist ein n-dotiertes Oberflächengebiet 52 epitaktisch aufgebracht, wobei zwischen dem Oberflächengebiet und dem Substrat eine stark n-dotierte vergrabene Schicht 54 angeordnet ist. An der Oberfläche 10 des Oberflächengebiets 52 ist eine p-dotierte Wanne 50 eingebracht, in die wiederum ein stark p-dotiertes Gebiet 40 sowie, dazu unmittelbar benachbart, ein stark n-dotiertes Gebiet 56 eingebracht ist, die beide über eine metallische Emitterelektrode 44 an der Oberfläche miteinander elektrisch verbunden sind. Eine an der Oberfläche angeordnete Isolationsoxidschicht 100 trennt die p-Wanne 50 von einer dazu benachbart in die Oberfläche eingebrachten stark n-dotierten Anschlußschicht 42, die über eine Kollektorelektrode 46 elektrisch kontaktiert werden kann. Die Anschlußschicht 42 überlappt mit einer in das Oberflächengebiet 52 eingebrachten, stark n-dotierten, eingelassenen bzw. Sinkerelektrode 540, die wiederum teilweise mit der vergrabenen Schicht 54 überlappt. Die Dotierung der p-Wanne 50 liegt typischerweise in einem Bereich von 10¹⁷cm⁻³. Die n-Dotierung des Oberflächengebiets 52 liegt typischerweise in einem Bereich von 10¹⁵cm⁻³, die Dotierung der stark n-dotierten Anschlußschicht in einem Bereich von typischerweise 10¹⁹cm⁻³.

Für den Einsatz einer derartigen Vorrichtung als ESD-Schutz ist die Sperrpolung des pn-Übergangs zwischen der p-Wanne 50 und dem Oberflächengebiet 52 relevant. Der Abstand zwischen der p-Wanne und der Anschlußschicht 42 ist derart dimensioniert, daß die mit zunehmender Sperrspannung wachsende Verarmungszone im Oberflächengebiet 52 die Anschlußschicht 42 erreicht, bevor die Durchbruchspannung zwischen der p-Wanne 50 und dem Oberflächengebiet 52 erreicht ist. Somit erfolgt zwischen der Wanne 50 und der Anschlußschicht 42 ein Durchbruch in Folge des Sperrschichtberührungseffekts.

Figur 2 zeigt ein Ausführungsbeispiel der erfindungsgemäßen Schutzvorrichtung. Gleiche Bezugszeichen wie in Figur 1 bezeichnen gleiche oder ähnliche Bestandteile und werden im folgenden nicht nochmals beschrieben. Zwischen der p-Wanne 50 und der Anschlußstruktur 540, 46 ist ein stark p-dotiertes Gebiet 500 in das Oberflächengebiet 52 eingebracht. Das Gebiet 500 weist eine höhere p-Dotierung auf als die Wanne 50; die Dotierstoffkonzentration im Gebiet 500 liegt typischerweise in einem Bereich von 5 x 10¹⁹ bis 10²⁰cm⁻³. Darüber hinaus ist das stark p-dotierte Gebiet 500 flacher ausgebildet als die p-Wanne 50, d.h. es ragt nicht so tief in das Oberflächengebiet 52 hinein wie die p-Wanne 50. Das Gebiet 500 ist über eine elektrische Verbindung 510 mit dem Basisgebiet 50 verbunden. Diese Verbindung 510 kann als metallische Leitung auf der Oberfläche des Halbleiterbauelements ausgebildet sein, wobei die Kontaktierung der p-Wanne 50 über ein stark p-dotiertes Kontaktgebiet 520 erfolgt, das in die p-Wanne 50 eingebracht ist. Zwischen dem Gebiet 500 und der p-Wanne 50 ist an der Oberfläche 10 des Bauelements eine Isolationsoxidschicht 530 angeordnet. Die Anschlußstruktur 540, 46 wahrt einen Abstand y von dem Gebiet 500, wobei y beispielsweise zwischen 3 und 8 µm liegt).

Durch den pn-Übergang zwischen dem Gebiet 500 und dem Oberflächengebiet 52 wird eine laterale integrierte Diode gebildet, die bei Beschaltung des Bauelements als Schutzvorrichtung dient, die in Sperrichtung geschaltet ist. Der Minuspol der zu schützenden Schaltung ist dabei an die Emitterelektrode angeschlossen, der Pluspol an die Kollektorelektrode. Nach erfolgtem Durchbruch dieser integrierten lateralen Diode bei Überschreiten eines bestimmten Spannungswertes (der Durchbruchspannung) wird die Basis des vertikalen Transistors so angesteuert, daß es zum vertikalen Transistoreffekt kommt. Das Bauelement springt auf die charakteristische Haltespannung des vertikalen Bipolartransistors; der laterale Diodendurchbruch erlischt, da die Haltespannung der vertikalen Transistordiode kleiner ist als die Diodendurchbruchspannung, der vertikale Transistor bleibt aktiviert. Das Gebiet 500 kann alternativ auch als "ausgelagertes Basisgebiet" betrachtet werden. Da das Gebiet 500 stärker dotiert ist als die Basis 50 und/oder durch die flachere Ausgestaltung im Vergleich zum Basisgebiet 50 schärfer von dem Oberflächengebiet 52 abgegrenzt ist, also einen höheren Dotierstoffgradienten zum Oberflächengebiet 52 hin aufweist als das Basisgebiet 50; wird im pn-Übergang des Gebietes 500 mit dem Oberflächengebiet 52 bei gegebener Spannung ein höheres elektrisches Feld erreicht, mithin bricht die Anordnung bei einer niedrigeren Spannung durch.

Durch Verkleinerung des Abstandes y kann die Durchbruchspannung weiter erniedrigt werden. Hierbei muß jedoch der Abstand sehr definiert gewählt werden, da ansonsten das stark n-dotierte Gebiet 540 zu nah an das stark p-dotierte Gebiet 500 gelangt und somit die Durchbruchspannung sehr leicht für die Anwendung zu niedrige Werte erreichen kann. Für y = 8ym beträgt die Durchbruchspannung zirka 37 Volt, für y = 7µm 34 Volt, für y = 6µm 25 Volt, für y = 5µm 13 Volt, für y = 4µm 7 Volt und für y = 3µm zirka 5 Volt. Die Haltespannung der Anordnung hingegen ist allein durch den vertikalen Transistor bzw. den Widerstandswert der Kollektoranbindung bestimmt.

Die Sinkerelektrode 540 ist für das Funktionsprinzip der Anordnung nicht erforderlich und kann daher weggelassen werden. In diesem Fall reicht es aus, eine starke n-dotierte Anschlußschicht vorzusehen, oberhalb der die Kollektorelektrode 46 angeordnet ist. Dadurch ist der Widerstandswert der Kollektorbindung lediglich erhöht und damit auch die Haltespannung gegenüber einer Anordnung mit Sinkerelektrode vergrößert, die Schutzfunktion ist jedoch weiterhin gewährleistet. Eine Sinkerelektrode ist aber nützlich, um die Schutzvorrichtung gegen andere Schaltkreise abzugrenzen und so parasitäre Effekte bzw. Leckströme ins Substrat zu unterbinden. Vorrichtungen wie in Figur 2 beschrieben sind auch mit vertauschten Dotierungstypen realisierbar.

Es ist auch möglich, die Gebiete 500 und 50 überlappend auszugestalten. Dann entfällt die Isolationsschicht 530.

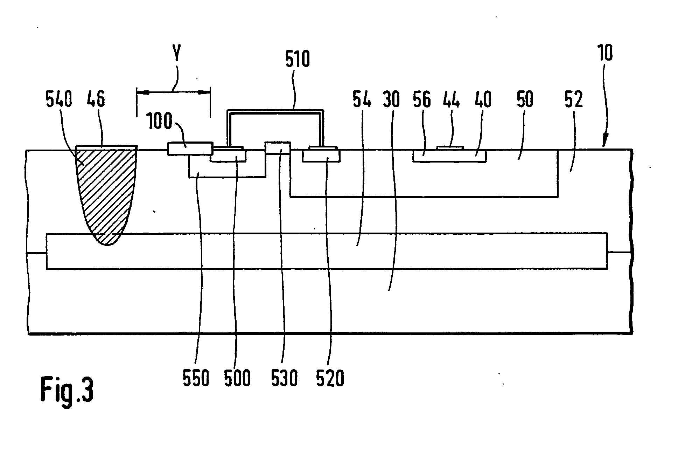

Im Unterschied zur Figur 2 zeigt Figur 3 eine Schutzvorrichtung, bei der das ausgelagerte Basisgebiet 500 in eine n-dotierte Wanne 550 eingebettet ist, die stärker dotiert ist als das Oberflächengebiet 52. Während das Oberflächengebiet, wie oben bereits erläutert, typischerweise eine Dotierstoffkonzentration von 10¹⁵cm⁻³ aufweist, ist die Wanne 550 mit einer Konzentration von ca. 10¹⁶cm⁻³ dotiert.

In Folge der n-Wanne 550 stellt sich ein schärferer pn-Übergang zwischen dem Gebiet 500 und dem umliegenden n-dotierten Gebiet ein als ohne diese zusätzliche Wanne. Dies stellt einen weiteren Beitrag zur Erniedrigung der Durchbruchspannung der Schutzvorrichtung dar, da infolge des steileren pn-Übergangs bei einer gegebenen Spannung ein höheres Feld an dem pn-Übergang erreicht wird.

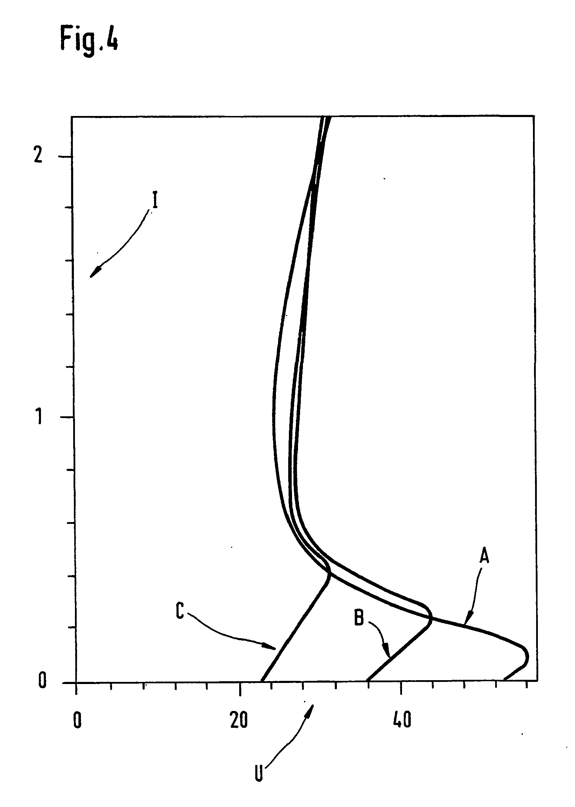

Figur 4 zeigt ein Strom-Spannungsdiagramm (I steht für Strom, U steht für Spannung) für die Anordnungen gemäß Figur 1 bis 3. Dabei zeigt die Kurve A den Verlauf für eine Anordnung gemäß Figur 1, die Kurve B den Verlauf für eine Anordnung gemäß Figur 2, und Kurve C für eine Anordnung gemäß Figur 3.

Liegt beispielsweise die Elektrode der Anordnung der Figur 1 auf Masse und die Kollektorelektrode 46 auf positivem Potential, so bricht gemäß Kurve a bei einer Spannung von ca. 52 Volt der pn-Übergang zwischen der Basiswanne 50 und dem Oberflächengebiet 52 in Folge des SperrschichtBerührungseffekts an der Anschlußschicht 42 durch. Erst wenn sich hiernach die Spannung auf ca. 56 Volt erhöht hat, wird der Emitter der vertikalen Transistordiode derart von Ladungsträgern umströmt, daß der pn-Übergang zwischen Emitter und Basis der vertikalen Transistordiode durchschaltet und ein vertikaler Strom fließt. Im Bereich zwischen 52 und 56 Volt fließt also zunächst ein rein lateraler Strom, bis in Folge des Zündens der vertikalen Transistordiode der Gesamtwiderstand zwischen Kollektor und Emitter deutlich abfällt und entsprechend die Spannung zwischen diesen beiden Elektroden auf einen Haltespannungswert im Bereich zwischen 20 und 30 Volt absinkt. Das vorgelagerte Basisgebiet 500 bewirkt aufgrund seiner höheren Dotierung und/oder seiner flacheren Ausgestaltung einen früheren Durchbruch und ein entsprechend früheres Einsetzen des lateralen Stromflusses bei einem Spannungswert zwischen Kollektor und Emitterelektrode von ca. 36 Volt. Der Spannungsbereich rein lateralen Stromflusses ist ausgeprägter, die Spannung steigt im Fall B noch bis auf 44 Volt an, bis dann auch hier die Transistordiode zündet und die Spannung zwischen ihren Elektroden auf den Wert der Haltespannung abfällt. Deutlich erkennbar ist die wesentlich niedrigere Durchbruchspannung von ca. 44 Volt im Vergleich zu den ca. 56 Volt bei der aus dem Stand der Technik bekannten Anordnung. Den Effekt der Diodenwanne 550 auf die Stromspannungscharakteristik zeigt schließlich Kurve C: Der Einsatz lateralen Stromflusses erfolgt bei einer noch niedrigeren Spannung von ca. 24 Volt, die Durchbruchspannung, also die Spannung, bei der der vertikale Stromfluß und damit ein Absinken der Spannung auf die Haltespannung einsetzt, ist ebenfalls weiter erniedrigt und beträgt nur noch ca. 31 Volt.

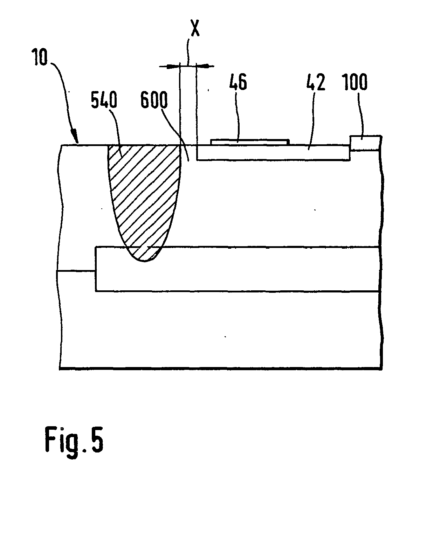

Figur 5 zeigt eine Variation der Schaltungsanordnungen nach Figur 2 und 3, die an sich aus der deutschen Patentanmeldung mit Aktenzeichen 199 17 155.6 bekannt ist, jedoch in vorteilhafter Weise auch auf Schutzvorrichtungen mit ausgelagerten Basisgebieten angewandt werden kann. Die gestrichelte Linie am rechten Rand der Abbildung markiert die Grenze, ab der die Anordnung identisch zur Figur 2 bzw. zur Figur 3 ausgestaltet ist. Lediglich im Teil links der gestrichelten Linie ist im Gegensatz zur Figur 2 bzw. Figur 3 eine separate Anschlußschicht 42 vorgesehen, die stark n-dotiert ist und zur Befestigung der Kollektorelektrode 46 dient. Wesentlich ist hierbei das Vorsehen eines Abstandes x zwischen der eingelassenen Elektrode 540 und der Anschlußschicht 42, so daß ein Zwischengebiet 600 entsteht, dessen Dotierstoffkonzentration zwischen der eingelassenen Elektrode und der Anschlußschicht ein lokales Minimum darstellt.

In Folge des Zwischengebiets ist die Anschlußschicht 42 nur sehr hochohmig mit der vergrabenen Schicht verbunden, da jeder mögliche Stromfluß zwischen der Anschlußschicht und der vergrabenen Schicht durch das relativ zur vergrabenen Schicht und zur Anschlußschicht schwach dotierte Oberflächengebiet verläuft. Dies führt jedoch dazu, daß im Falle eines Durchbruchs die Transistordiode eine im Vergleich zur Anordnung nach Figur 2 bzw. Figur 3 erhöhte Haltespannung aufweist. Über den Abstand x der Anschlußsschicht zur Sinkerelektrode ist also der Wert der Haltespannung einstellbar, er nimmt mit größer werdendem x zu.

## Patentansprüche

1. Schutzvorrichtung gegen elektrostatische Entladungen, für eine in einem Halbleitersubstrat (30) angeordnete integrierte Schaltung, mit einer vertikal zur Oberfläche (10) des Halbleitersubstrats in einem Oberflächengebiet (52) angeordneten Transistordiode (44,56,40,50,52,54), wobei deren Basis-Emitter-Struktur (44,56,40,50) an der Oberfläche eingebracht und deren Kollektor als vergrabene Schicht (54) ausgebildet ist, wobei lateral versetzt zur Transistordiode eine Anschlußstruktur (540, 46) zur Kontaktierung der vergrabenen Schicht (54) in dem Oberflächengebiet (52) angeordnet ist, so daß bei Polung der Transistordiode in Sperrichtung eine Sperrschichtberührung an der Anschlußsstruktur erfolgt, bevor ein Durchbruch zwischen Oberflächengebiet (52) und Basis-Emitter-Struktur (44,56,40,50) erfolgen kann, **dadurch gekennzeichnet, daß** zwischen der Basis-Emitter-Struktur (44,56,40,50) und der Anschlußstruktur (540, 46) ein Gebiet (500) in das Oberflächengebiet eingebracht ist, dessen Dotierungstyp entgegengesetzt gewählt ist zum Dotierungstyp des Oberflächengebiets (52), wobei das Gebiet (500) mit der Basis-Emitter-Struktur niederohmig verbunden (510) ist, so daß durch den Halbleiterübergang zwischen dem Gebiet und dem das Gebiet umgebenden Teil des Oberflächengebiets eine laterale Diode gebildet ist zur Ansteuerung der vertikalen Transistordiode, wobei die Dotierstoffkonzentration im Gebiet (500) höher ist als im Basisgebiet (50) der Basis-Emitter-Struktur (44,56,40,50) und/oder das Gebiet (500) flacher ist als das Basisgebiet (50).

2. Schutzvorrichtung nach Anspruch 1, **dadurch gekennzeichnet, daß** das Gebiet (500) in einer entgegengesetzt dotierten, in das Oberflächengebiet eingebrachten Wanne (540) angeordnet ist, deren Dotierstoffkonzentration höher ist als die des Oberflächengebiets (52).

3. Schutzvorrichtung nach Anspruch 1 oder 2, **dadurch gekennzeichnet, daß** zwischen dem Gebiet (500) und der Anschlußstruktur an der Oberfläche des Oberflächengebiets (52) eine Isolationsoxidschicht (100) angeordnet ist.

4. Schutzvorrichtung nach einem der vorhergehenden Ansprüche, **dadurch gekennzeichnet, daß** zwischen dem Gebiet (500) und der Basis-Emitter-Struktur (44,56,40,50) eine weitere Isolationsoxidschicht (530) angeordnet ist.

5. Schutzvorrichtung nach einem der vorhergehenden Ansprüche, **dadurch gekennzeichnet, daß** der Abstand (y) zwischen der Anschlußstruktur (540, 46) und dem Gebiet (500) entsprechend einer zu erzielenden Durchbruchsspannung der Transistordiode bemessen ist.

6. Schutzvorrichtung nach einem der vorhergehenden Ansprüche, **dadurch gekennzeichnet, daß** die Anschlußstruktur eine in das Oberflächengebiet (52) eingebrachte eingelassene Elektrode (540) aufweist, die mit der vergrabenen Schicht (54) überlappt und bis zur Oberfläche reicht.

7. Schutzvorrichtung nach einem der vorhergehenden Ansprüche, **dadurch gekennzeichnet, daß** die Anschlußstruktur eine Anschlußschicht (42) aufweist, an die eine Kollektorelektrode (46) angeschlossen ist.

8. Schutzvorrichtung nach Anspruch 7, **dadurch gekennzeichnet, daß** die Anschlußschicht (42) auf den von der Oberfläche abgewandten Seiten vollständig von Bereichen des Oberflächengebiets umgeben ist, die eine geringere Dotierung aufweisen als die Anschlußschicht (42), so daß ein Strompfad zwischen der vergrabenen Schicht (54) und der Anschlußschicht (42) stets über die Bereiche verlaufen muß.

9. Schutzvorrichtung nach Anspruch 6 und 8, **dadurch gekennzeichnet, daß** ein von Null verschiedener Abstand (x) zwischen der eingelassenen Elektrode (540) und der Anschlußschicht (42) entsprechend der zu erzielenden Haltespannung der Transistordiode bemessen ist.

10. Schutzvorrichtung nach einem der vorhergehenden Ansprüche, **dadurch gekennzeichnet, daß** das Halbleitersubstrat (30) p-dotiert ist, wobei das Oberflächengebiet (52) als n-dotierte epitaktische Schicht ausgebildet ist.

11. Schutzvorrichtung nach Anspruch 10, **dadurch gekennzeichnet, daß** die Basis-Emitter-Struktur (44,56,40,50) eine die Basis der Transistordiode bildende, in das Oberflächengebiet (52) eingebrachte p-dotierte Wanne (50) aufweist.

12. Schutzvorrichtung nach Anspruch 11, **dadurch gekennzeichnet, daß** in die p-dotierte Wanne ein stark p-dotiertes Gebiet (40) zur Kontaktierung der p-Wanne sowie ein stark n-dotiertes Gebiet (56) eingebracht sind, wobei die beiden Gebiete (40, 56) miteinander über eine metallische Leitung, insbesondere über eine an der Oberfläche aufgebrachte Emitterelektrode (44), in elektrischer Verbindung stehen.

13. Schutzvorrichtung nach einem der Ansprüche 10 bis 12, **dadurch gekennzeichnet, daß** die vergrabene Schicht (54) stark n-dotiert und zwischen dem Substrat (30) und dem Oberflächengebiet (52) angeordnet ist, wobei sie sich zumindest unterhalb der Basis-Emitter-Struktur erstreckt.

14. Schutzvorrichtung nach Anspruch 7, **dadurch gekennzeichnet, daß** sich die vergrabene Schicht auch unterhalb der Anschlußschicht (42) erstreckt.

15. Schutzvorrichtung nach Anspruch 7 und 10, **dadurch gekennzeichnet, daß** die Anschlußschicht (42) stark n-dotiert ist.

16. Schutzvorrichtung nach Anspruch 6 und 10, **dadurch gekennzeichnet, daß** die Sinkerelektrode (540) stark n-dotiert ist.

17. Schutzvorrichtung nach einem der Anspruch 10 bis 16, **gekennzeichnet durch** vertauschte Dotierungstypen.

## Claims

1. Protection device against electrostatic discharges, for an integrated circuit arranged in a semiconductor substrate (30), comprising a transistor diode (44, 56, 40, 50, 52, 54) arranged vertically with respect to the surface (10) of the semiconductor substrate in a surface region (52), the base-emitter structure (44, 56, 40, 50) of said transistor diode being introduced at the surface and the collector of said transistor diode being formed as a buried layer (54), there being arranged in a manner laterally offset with respect to the transistor diode a connection structure (540, 46) for making contact with the buried layer (54) in the surface region (52), so that, in the case where the transistor diode is reversed-biased, a punch-through is effected at the connection structure before a breakdown can be effected between surface region (52) and base-emitter structure (44, 56, 40, 50), **characterized in that** a region (500) is introduced into the surface region between the base-emitter structure (44, 56, 40, 50) and the connection structure (540, 46), the doping type of said region being chosen to be opposite to the doping type of the surface region (52), the region (500) being connected (510) to the base-emitter structure with low impedance, so that a lateral diode is formed by the semiconductor junction between the region and that part of the surface region which surrounds the region, for the driving of the vertical transistor diode, the dopant concentration being higher in the region (500) than in the base region (50) of the base-emitter structure (44, 56, 40, 50) and/or the region (500) being shallower than the base region (50).

2. Protection device according to Claim 1, **characterized in that** the region (500) is arranged in an oppositely doped well (540) which is introduced into the surface region and the dopant concentration of which is higher than that of the surface region (52).

3. Protection device according to Claim 1 or 2, **characterized in that** an insulation oxide layer (100) is arranged between the region (500) and the connection structure at the surface of the surface region (52).

4. Protection device according to one of the preceding claims, **characterized in that** a further insulation oxide layer (530) is arranged between the region (500) and the base-emitter structure (44, 56, 40, 50).

5. Protection device according to one of the preceding claims, **characterized in that** the distance (y) between the connection structure (540, 46) and the region (500) is dimensioned in a manner corresponding to a breakdown voltage of the transistor diode that is to be obtained.

6. Protection device according to one of the preceding claims, **characterized in that** the connection structure has a sunk-in electrode (540) which is introduced into the surface region (52), overlaps the buried layer (54) and reaches as far as the surface.

7. Protection device according to one of the preceding claims, **characterized in that** the connection structure has a connection layer (42), to which a collector electrode (46) is connected.

8. Protection device according to Claim 7, **characterized in that** the connection layer (42), on the sides remote from the surface, is completely surrounded by regions of the surface region which have a lower doping than the connection layer (42), so that a current path between the buried layer (54) and the connection layer (42) always has to run via the regions.

9. Protection device according to Claims 6 and 8, **characterized in that** a distance (x) different from zero between the sunk-in electrode (540) and the connection layer (42) is dimensioned in a manner corresponding to the snap-back voltage of the transistor diode that is to be obtained.

10. Protection device according to one of the preceding claims, **characterized in that** the semiconductor substrate (30) is p-doped, the surface region (52) being formed as an n-doped epitaxial layer.

11. Protection device according to Claim 10, **characterized in that** the base-emitter structure (44, 56, 40, 50) has a p-doped well (50) which is introduced into the surface region (52) and forms the base of the transistor diode.

12. Protection device according to Claim 11, **characterized in that** a heavily p-doped region (40) for making contact with the p-type well and also a heavily n-doped region (56) are introduced into the p-doped well, the two regions (40, 56) being electrically connected to one another via a metallic line, in particular via an emitter electrode (44) applied to the surface.

13. Protection device according to one of the Claims 10 to 12, **characterized in that** the buried layer (54) is heavily n-doped and arranged between the substrate (30) and the surface region (52), said layer extending at least below the base-emitter structure.

14. Protection device according to Claim 7, **characterized in that** the buried layer also extends below the connection layer (42).

15. Protection device according to Claims 7 and 10, **characterized in that** the connection layer (42) is heavily n-doped.

16. Protection device according to Claims 6 and 10, **characterized in that** the sinker electrode (540) is heavily n-doped.

17. Protection device according to one of Claims 10 to 16, **characterized by** interchanged doping types.

## Revendications

1. Dispositif de protection contre les décharges électrostatiques, pour un circuit intégré dans un substrat à semi-conducteurs (30) et comprenant une diode transistor (44, 56, 40, 50, 52, 54) installée verticalement par rapport à la surface (10) du substrat à semi-conducteurs dans une région de surface (52), sa structure d'émetteur de base (44, 56, 40, 50) étant rapportée sur la surface et son collecteur ayant la forme d'une couche enterrée (54), avec une structure de raccordement (540, 46) qui, pour entrer en contact avec la couche enterrée (54) est décalée latéralement par rapport à la diode transistor et disposée dans la région de surface (52), de sorte que, lorsque la polarité de la diode transistor est dans la direction de blocage, un contact de la couche de blocage se produit avec la structure de raccordement avant qu'un claquage entre la région de surface (52) et la structure d'émetteur de base (44, 56, 40, 50) puisse se produire,
**caractérisé en ce que**
entre la structure d'émetteur de base (44, 56, 40, 50) et la structure de raccordement (540, 46), une région (500) est rapportée dans la région de surface avec un type de dopage choisi opposé au type de dopage de la région de surface (52), la région (500) étant reliée à la structure d'émetteur de base avec une faible impédance (510) de sorte que la jonction du semi-conducteur entre la région et la partie de la région de surface entourant cette région permet de former une diode latérale pour exciter la diode transistor verticale, la concentration de matière dopante dans la région (500) étant supérieure à celle dans la région de base (50) de la structure d'émetteur de base (44, 56, 40, 50), et/ou la région (500) étant plus plate que la région de base (50).

2. Dispositif de protection selon la revendication 1,
**caractérisé en ce que**
la région (500) est disposée dans une cuve (540) de dopage opposé et rapportée dans la région de surface, sa concentration en matière dopante étant supérieure à celle de la région de surface (52).

3. Dispositif de protection selon la revendication 1 ou 2,
**caractérisé en ce qu'**
une couche d'oxyde d'isolement (100) est disposée sur la surface de la région de surface (52) entre la région (500) et la structure de raccordement.

4. Dispositif de protection selon l'une des revendications précédentes,
**caractérisé en ce qu'**
une autre couche d'oxyde d'isolement (530) est disposée entre la région (500) et la structure d'émetteur de base (44, 56, 40, 50).

5. Dispositif de protection selon l'une des revendications précédentes,
**caractérisé en ce que**
la distance (v) entre la structure de raccordement (540, 46) et la région (500) est dimensionnée en fonction d'une tension de claquage de la diode transistor à obtenir.

6. Dispositif de protection selon l'une des revendications précédentes,
**caractérisé en ce que**
la structure de raccordement présente une électrode encastrée (540) rapportée dans la région de surface (52) et qui se chevauche avec la couche enterrée (54) pour arriver jusqu'à la surface.

7. Dispositif de protection selon l'une des revendications précédentes,
**caractérisé en ce que**
la structure de raccordement présente une couche de raccordement (42) à laquelle est raccordée une électrode collecteur (46).

8. Dispositif de protection selon la revendication 7,
**caractérisé en ce que**
la couche de raccordement (42) est entièrement entourée des régions de la région de surface sur les côtés détournés de la surface, ces régions présentant un dopage inférieur à la couche de raccordement (42) de sorte qu'un chemin de courant circule constamment sur les régions entre la couche enterrée (54) et la couche de raccordement (42).

9. Dispositif de protection selon les revendications 6 et 8,
**caractérisé en ce qu'**
une distance (x) différente de zéro entre l'électrode encastrée (540) et la couche de raccordement (42) est dimensionnée en fonction de la tension de blocage de la diode transistor à obtenir.

10. Dispositif de protection selon l'une des revendications précédentes,
**caractérisé en ce que**
le substrat à semi-conducteurs (30) est dopé p, la région de surface (52) ayant la forme d'une couche épitaxiée dopée n.

11. Dispositif de protection selon la revendication 10,
**caractérisé en ce que**
la structure d'émetteur de base (44, 56, 40, 50) présente une cuve (50) dopée p rapportée dans la région de surface (52) et formant la base de la diode transistor.

12. Dispositif de protection selon la revendication 11,
**caractérisé en ce qu'**
une région fortement dopée p (40) destinée à venir en contact avec la cuve p ainsi qu'une région fortement dopée n (56) sont rapportées dans la cuve dopée p, les deux régions (40, 56) étant reliées électriquement ensemble par une ligne métallique, en particulier par une électrode d'émetteur (44) appliquée sur la surface.

13. Dispositif de protection selon l'une des revendications 10 à 12,
**caractérisé en ce que**
la couche enterrée (54) est fortement dopée n et disposée entre le substrat (30) et la région de surface (52), et s'étend au moins en dessous de la structure d'émetteur de base.

14. Dispositif de protection selon la revendication 7,
**caractérisé en ce que**
la couche enterrée s'étend également en dessous de la couche de raccordement (42).

15. Dispositif de protection selon la revendication 7 et 10,
**caractérisé en ce que**
la couche de raccordement (42) est fortement dopée n.

16. Dispositif de protection selon la revendication 6 et 10,
**caractérisé en ce que**
l'électrode enfoncée (540) est fortement dopée n.

17. Dispositif de protection selon l'une des revendications 10 à 16,
**caractérisé par**
des types de dopage intervertis.
